(19) **Europäisches Patentamt European Patent Office Office européen des brevets**

(11) **EP 1 323 671 B1**

(12) **FASCICULE DE BREVET EUROPEEN**

(45) Date de publication et mention
de la délivrance du brevet:
**24.04.2013   Bulletin 2013/17**

(51) Int Cl.:
*C23C 16/26* (2006.01)          *C23C 16/511* (2006.01)
*C30B 25/10* (2006.01)          *C01B 31/02* (2006.01)
*H05H 1/46* (2006.01)          *B82B 3/00* (2006.01)
*B82Y 30/00* (2011.01)          *B82Y 10/00* (2011.01)
*H01J 37/32* (2006.01)

(21) Numéro de dépôt: **02293242.0**

(22) Date de dépôt: **24.12.2002**

(54) **Procédé de fabrication d'au moins un nanotube entre deux éléments électriquement conducteurs et dispositif pour mettre en oeuvre un tel procédé**

Verfahren zur Herstellung von mindestens eines Nanorohres zwischen zwei elektrisch leitenden Elementen sowie Vorrichtung zur Durchführung des Verfahrens

Process for the fabrication of at least one nanotube between two electrically conductive elements and device for carrying out this process

(84) Etats contractants désignés:
**AT BE BG CH CY CZ DE DK EE ES FI FR GB GR IE IT LI LU MC NL PT SE SI SK TR**

(30) Priorité: **26.12.2001   FR 0116871**

(43) Date de publication de la demande:
**02.07.2003   Bulletin 2003/27**

(73) Titulaire: **Commissariat à l'Énergie Atomique et aux Énergies Alternatives 75015 Paris (FR)**

(72) Inventeurs:
• **Delaunay, Marc**
  **38240 Meylan (FR)**
• **Senillou, Anne**
  **38120 Saint-Egreve (FR)**

• **Semeria Marie-Noélle**
  **38250 Saint Nizier du Moucherotte (FR)**

(74) Mandataire: **Simonnet, Christine et al Cabinet BREVALEX 95, rue d'Amsterdam 75378 Paris Cedex 8 (FR)**

(56) Documents cités:
**EP-A- 0 967 844          WO-A-01/03158
WO-A-01/44796          WO-A-02/34669**

• **TSAI S H ET AL: "Synthesis and characterization of the aligned hydrogenated amorphous carbon nanotubes by electron cyclotron resonance excitation" THIN SOLID FILMS, ELSEVIER-SEQUOIA S.A. LAUSANNE, CH, vol. 366, no. 1-2, mai 2000 (2000-05), pages 11-15, XP004203828 ISSN: 0040-6090**

**Description**

**DOMAINE TECHNIQUE**

Le domaine technique de la présente invention est celui des procédés et des dispositifs de fabrication de nanotubes et/ou de nanofils (nanotubes pleins) comportant des atomes de carbone, entre deux éléments électriquement conducteurs, les deux éléments électriquement conducteurs étant prélocalisés sur un substrat. Par « nanotubes », on entend des tubes comportant des atomes de carbone, dont le diamètre est compris entre quelques nanomètres et quelques dizaines de nanomètres, et de préférence de 1 à 100 nm.

De tels ensembles, constitués par deux éléments électriquement conducteurs reliés entre eux par un nanotube, sont notamment utilisés dans le cadre de la réalisation de nano-composants pour le domaine de l'électronique moléculaire. A titre d'exemple, ces ensembles peuvent trouver une application dans les transistors à effet de champ, les mémoires du type RAM ou encore tout type de jonction électronique.

Il est en effet possible d'utiliser de tels ensembles afin de réaliser des architectures logiques ou des mémoires à très haute densité, ces ensembles présentant l'avantage d'être de conception relativement simple.

Les ensembles mentionnés ci-dessus peuvent également s'appliquer au domaine de la biotechnologie, dans le cadre de la réalisation de nano-capteurs chimiques, ou de biocapteurs par greffage de molécules.

**ETAT DE LA TECHNIQUE ANTERIEURE**

De l'art antérieur, on connaît trois principaux types de procédé de fabrication de nanotubes et de nanofils.

Il s'agit des méthodes de dépôt physique en phase vapeur (méthode PVD traduit de l'anglais « Physical Vapor Deposition »), des méthodes de dépôt chimique en phase vapeur (méthode CVD traduit de l'anglais « Chemical Vapor Deposition »), et enfin des méthodes CVD hybrides consistant à mettre en oeuvre une méthode CVD combinée à un plasma créé par micro-ondes ou par filament.

Cependant, ces méthodes classiques, notamment décrites dans les documents « C. Bower et al., Applied Physics Letters, Volume 77 P.830 (2000) » et « Y.C. Choi et al., Journal of Applied Physics, Volume 88 P.4898 (2000) », sont particulièrement utilisées dans le cadre de la réalisation de nanotubes s'étendant perpendiculairement à une surface sur laquelle est amorcée la précipitation, et non pour effectuer une jonction de deux éléments électriquement conducteurs se situant sur un substrat, ce dernier type de procédé étant beaucoup plus complexe à réaliser.

Dans ce domaine des ensembles constitués de deux éléments électriquement conducteurs reliés entre eux par l'intermédiaire d'un ou de plusieurs nanotubes, on note néanmoins que plusieurs réalisations ont déjà été proposées.

Une première approche, décrite dans le document « H. Postma et al., Advanced Material N°17 P.1299 (2000) », consiste à fabriquer une pluralité de nanotubes avant de les répartir sur un substrat. Il est ensuite nécessaire de les manipuler de façon à les positionner correctement par rapport aux électrodes à raccorder, puis d'effectuer la liaison métallique avec ces électrodes.

Cette méthode reste très fastidieuse, dans la mesure où l'opération de fabrication des nanotubes ainsi que l'opération de raccordement des ces nanotubes avec les électrodes, sont deux étapes à effectuer nécessairement successivement. La méthode proposée est donc totalement incompatible avec la production de masse. De plus, la résistance électrique de contact nanotube-électrodes est très élevée et non contrôlée, celle-ci pouvant atteindre 10 M$\Omega$.

Une autre méthode décrite dans le document « H.T. Soh et al., Applied Physics Letters, Vol.75 N°5 p.627 (1999) » consiste en la mise en oeuvre préalable de deux micro-zones catalytiques à l'extrémité de deux électrodes. Ensuite, la fabrication des nanotubes est effectuée à haute température, en utilisant une méthode CVD classique dans laquelle du méthane est employé en tant que gaz à ioniser/dissocier.

Cette méthode de fabrication nécessite cependant que l'on coupe les nanotubes qui ont été fabriqués en surnombre. Ainsi, cette méthode n'est pas non plus adaptée à la production de masse, notamment en raison de l'ajout d'une étape ultime de nettoyage de l'ensemble formé par le nanotube et les électrodes.

Enfin, une dernière méthode décrite dans le document « Y.Y. Wei et G. Eres, Applied Physics Letters, Vol.76 N°25 p.3759 (2000) » consiste à recouvrir deux micro-électrodes d'un catalyseur, puis à utiliser une méthode CVD classique à l'aide de l'acétylène, pour obtenir la jonction par nanotubes entre ces deux micro-électrodes.

Comme dans la méthode précédente, bien que la connexion aux électrodes des nanotubes se réalise durant la fabrication de ces derniers, la méthode proposée reste incontrôlable quant au nombre de nanotubes fabriqués entre ces deux électrodes. De plus, on ne maîtrise pas non plus totalement la qualité de la jonction, ce qui force à conserver uniquement les nanotubes pour lesquels la connexion aux électrodes s'est effectuée sans encombre et avec succès.

D'autre part, on connaît le document WO 02/34669. Ce document divulgue un procédé et un dispositif de dépôt par plasma à la résonance cyclotron électronique de nanotubes de carbone monoparois, sur un substrat exempt de catalyseur, par injection d'une puissance micro-ondes dans une chambre de dépôt comprenant une structure magnétique de confinement à miroir magnétique, et au moins une zone de résonance cycloton électronique.

EP 1 323 671 B1

La zone de résonnance fait face au substrat moyennant quoi, on provoque, sous une pression inférieure à $10^{-3}$ mbar, la dissociation et/ou l'ionisation d'un gaz contenant du carbone dans ledit miroir magnétique au centre de la chambre de dépôt, en produisant des espèces qui vont se déposer sur le substrat 2 qui est chauffé.

## EXPOSÉ DE L'INVENTION

Le but de la présente invention est donc de présenter un procédé de fabrication de nanotubes entre deux éléments électriquement conducteurs, remédiant au moins partiellement aux inconvénients cités ci-dessus, relatifs aux réalisations de l'art antérieur.

De plus, un autre but de l'invention est de présenter un dispositif susceptible de mettre en oeuvre un procédé de fabrication, tel que celui répondant au but mentionné ci-dessus.

Pour ce faire, l'invention a tout d'abord pour objet un procédé de fabrication d'au moins un nanotube entre deux éléments électriquement conducteurs situés sur un substrat, le procédé mettant en oeuvre, dans une chambre de dépôt, une puissance micro-ondes, un champ magnétique, ainsi qu'au moins une zone de résonance cyclotron électronique favorisant l'ionisation et/ou la dissociation d'un gaz contenant du carbone injecté dans la chambre de dépôt.

Selon l'invention, l'injection du gaz contenant du carbone est réalisée à faible pression à l'intérieur de la chambre de dépôt, entraînant l'ionisation et/ou la dissociation de ce gaz dans chaque zone de résonance cyclotron électronique, les ions et les électrons produits étant localisés sur les lignes de champ du champ magnétique mis en oeuvre dans la chambre de dépôt. De plus le procédé comprend en outre une opération d'écrantage des différentes espèces produites dans chaque zone de résonance cyclotron électronique, afin d'autoriser exclusivement aux radicaux libres non-condensables produits du type $CxHy°$, l'accès à une zone de dépôt adjacente à au moins une partie du substrat comprenant les deux éléments électriquement conducteurs, pour réaliser ledit nanotube.

Avantageusement, le procédé selon l'invention conduit à l'obtention d'un plasma à la résonance cyclotron électronique magnétisé à basse pression. Les ions et les électrons produits dans le plasma sont localisés sur les lignes de champ du champ magnétique, et circulent donc à l'intérieur de la chambre de dépôt selon une direction imposée, correspondant à la direction des lignes de champ du champ magnétique. Par conséquent, en opérant un écrantage des différentes espèces présentes dans le plasma, on peut facilement interdire aux ions et aux électrons l'accès à la zone de dépôt dans laquelle se situent les éléments électriquement conducteurs à raccorder. De plus, les autres espèces contenues dans le plasma, à savoir les radicaux libres non-magnétisés, circulent librement à l'intérieur de la chambre de dépôt. Ainsi, les radicaux libres non-condensables du type $CxHy°$ pénètrent facilement dans de la zone de dépôt, afin de former le nanotube de liaison entre les deux éléments électriquement conducteurs.

Avec la mise en oeuvre d'un tel procédé, les espèces nuisibles à la croissance des nanotubes, telles que les ions, les électrons et l'ensemble des espèces directement condensables, sont maintenues à l'écart de la zone de dépôt où seuls les radicaux libres non-condensables du type $CxHy°$ sont autorisés à pénétrer, afin de permettre la réalisation d'un nanotube de qualité.

La présence d'un plasma à la résonance cyclotron électronique permet de produire de manière avantageuse, un ensemble de radicaux libres organiques plus dissociés et plus réactifs que ceux produits dans les méthodes CVD classiques mises en oeuvre dans les réalisations de l'art antérieur, favorisant ainsi le bon déroulement de la croissance des nanotubes d'un élément conducteur à l'autre. De plus, avec un tel procédé, la précipitation des nanotubes d'un élément électriquement conducteur à un autre, s'effectue avantageusement en épousant la partie du substrat située entre ces deux éléments. En outre, la structure de la connexion obtenue entre les deux éléments est avantageusement différente de la structure des nanotubes se trouvant sous la forme d'une « toile d'araignée », ce dernier type de structure n'étant en aucun cas approprié pour la liaison à fabriquer.

Avantageusement, la résistance électrique du contact entre le nanotube obtenu par le procédé selon l'invention et les éléments électriquement conducteurs, reste faible par rapport aux résistances obtenues selon les procédés de l'art antérieur.

Selon un mode de réalisation préféré de l'invention, l'opération d'écrantage est réalisée en interposant une plaque métallique entre la zone de résonance cyclotron électronique et les éléments électriquement conducteurs. De plus, la plaque métallique est sensiblement perpendiculaire aux lignes de champ du champ magnétique appliqué dans la chambre de dépôt, de sorte que les ions et les électrons produits ne pénètrent pas dans la zone de dépôt.

De préférence, une direction de croissance de chaque nanotube est favorisée par l'application, dans la zone de dépôt, d'au moins l'un des éléments pris parmi le groupe constitué d'un gradient thermique, d'un champ magnétique ou d'un champ électrique. De manière avantageuse, l'application de ces moyens spécifiques permet d'augmenter la probabilité de connexion entre deux éléments électriquement conducteurs, en favorisant une direction de propagation des nanotubes.

De façon préférée, le procédé comprend les étapes suivantes :

- chauffage du substrat,

- mise en oeuvre de la puissance micro-ondes à l'intérieur de la chambre de dépôt,
- injection du gaz contenant du carbone,
- application du champ magnétique à l'intérieur de la chambre de dépôt, de façon à créer des lignes de champ sensiblement perpendiculaires au substrat et entraîner l'ionisation et/ou la dissociation du gaz dans la zone de résonance cyclotron électronique, de sorte que les ions et les électrons produits soient localisés sur les lignes de champ du champ magnétique,
- écrantage des espèces produites afin d'autoriser exclusivement aux radicaux libres non-condensables du type $CxHy°$ l'accès à la zone de dépôt.

Préférentiellement, l'opération de chauffage du substrat se réalise à une température comprise entre environ 500°C et environ 700°C, cette température permettant de fournir l'énergie d'activation nécessaire à la croissance des nanotubes.

Avantageusement, pour des raisons économiques, on utilise un générateur de puissance micro-ondes à une fréquence de l'ordre de 2,45 GHz. Bien entendu, on peut également travailler à plus haute ou plus basse fréquence.

Le gaz contenant du carbone est choisi de façon avantageuse parmi les alcanes, les alcènes, les alcynes, ainsi que leurs mélanges.

De préférence, la faible pression d'injection du gaz contenant du carbone est inférieure à environ $3.10^{-3}$ mbar, cette faible pression administrée augmentant l'énergie des électrons.

Le champ magnétique appliqué dans la chambre de dépôt est de préférence du type miroir magnétique fortement déséquilibré, le champ magnétique étant maximum au niveau de l'injection de la puissance micro-ondes, minimum au niveau du centre de la chambre de dépôt et grandissant à nouveau en approchant du substrat. Notons que ce type de miroir magnétique est réalisé pour faire du confinement.

Préférentiellement, les éléments électriquement conducteurs comprennent au moins une zone contenant au moins un élément choisi parmi le fer, le nickel, le cobalt ou tout autre métal ou alliage ayant des propriétés catalytiques de fixation et de déshydrogénation des radicaux libres non-condensables du type $CxHy°$.

L'invention a également pour objet un dispositif pour réaliser au moins un nanotube entre deux éléments électriquement conducteurs se situant sur un substrat, le dispositif comprenant :

- une chambre de dépôt,
- des moyens d'injection d'une puissance micro-ondes à l'intérieur de la chambre de dépôt,
- des moyens permettant de créer un champ magnétique à l'intérieur de la chambre de dépôt,
- au moins une zone de résonance cyclotron électronique à l'intérieur de la chambre de dépôt.

Selon l'invention, le dispositif comprend de plus :

- des moyens d'injection aptes à introduire à faible pression un gaz contenant du carbone, à l'intérieur de la chambre de dépôt,
- un écran délimitant une zone de dépôt adjacente à au moins une partie du substrat comprenant les deux éléments électriquement conducteurs et uniquement accessible aux radicaux libres non-condensables du type $CxHy°$.

D'autres caractéristiques et avantages de l'invention apparaîtront dans la description détaillée, non limitative, ci-dessous.

## BRÈVE DESCRIPTION DES DESSINS

Cette description sera faite au regard des dessins annexés parmi lesquels :

- la figure 1 représente une vue schématique en coupe de face, d'un dispositif pour réaliser au moins un nanotube entre deux éléments électriquement conducteurs, selon un mode de réalisation préféré de l'invention, et
- la figure 2 représente une vue schématique, à plus grande échelle, d'une partie de la chambre de dépôt du dispositif de la figure 1.

## EXPOSÉ DÉTAILLÉ D'UN MODE DE RÉALISATION PRÉFÉRÉ

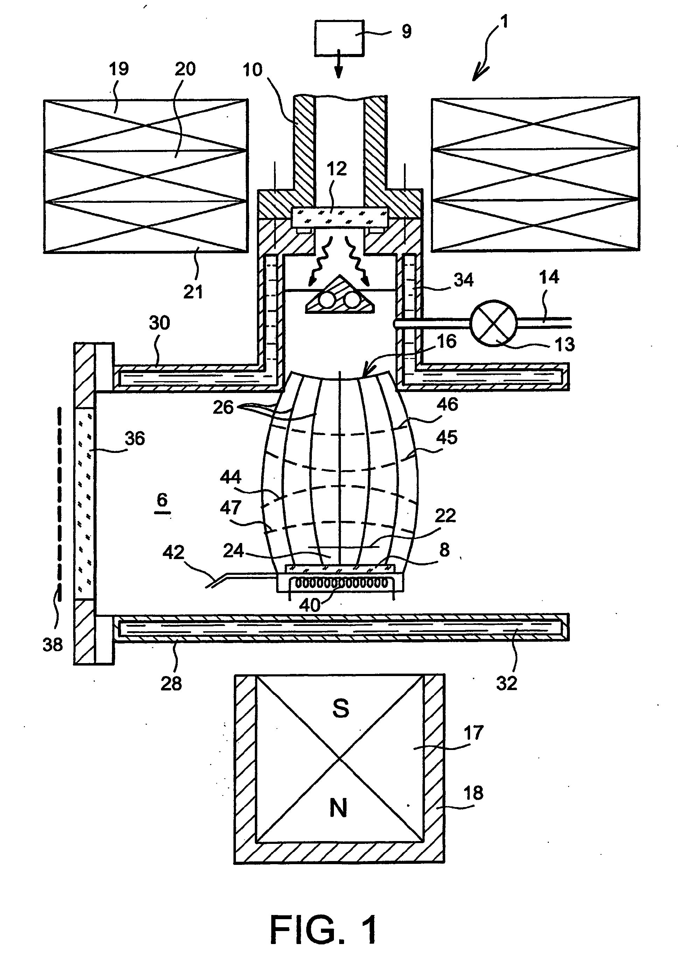

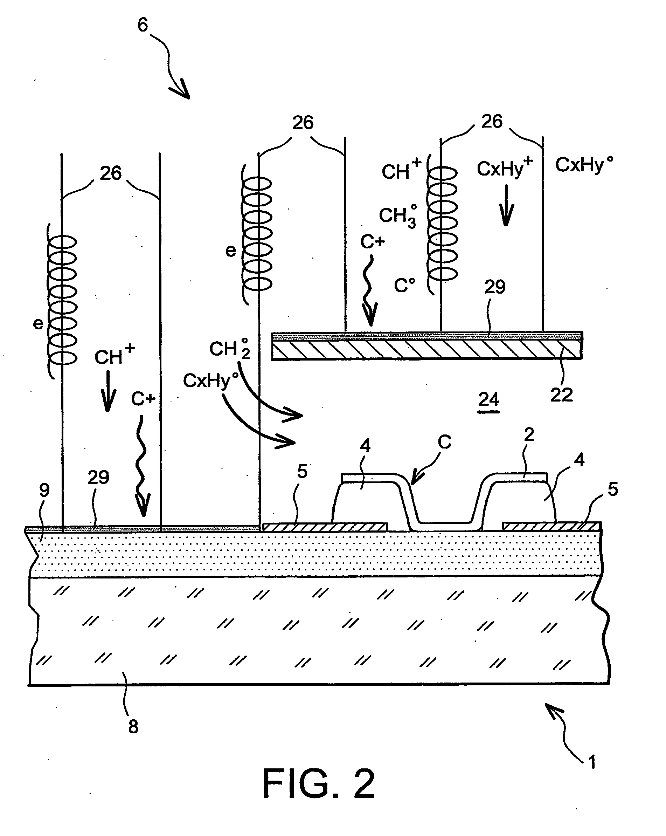

En référence aux figures 1 et 2, on voit un dispositif 1 pour réaliser par plasma à la résonance cyclotron électronique au moins un nanotube 2, entre deux éléments électriquement conducteurs 4. Ces éléments électriquement conducteurs 4 sont de préférence des plots métalliques comprenant une zone contenant au moins un élément tel que le fer, le nickel, le cobalt ou tout autre métal ou alliage ayant des propriétés catalytiques de fixation et de déshydrogénation des radicaux libres non-condensables du type CxHy°.

Il est à noter que chacun des éléments électriquement conducteurs 4 est positionné sur une électrode 5 de connexion électrique.

Toujours en référence aux figures 1 et 2, le dispositif 1 comprend une chambre de dépôt 6, à l'intérieur de laquelle se trouve un substrat 8, de préférence en silicium, comprenant une couche isolante 9, de préférence en $SiO_2$. Sur cette couche isolante 9, reposent les électrodes 5 ainsi qu'une pluralité d'éléments électriquement conducteurs, dont les deux éléments 4 destinés à être raccordés.

La chambre de dépôt 6 est partiellement délimitée par des structures en acier inoxydable à double paroi 28,30, couplées à des systèmes de refroidissement 32,34. On peut également prévoir un hublot d'observation 36 et un grillage de protection 38 afin de permettre au manipulateur d'avoir un accès visuel sur les opérations réalisées.

Au niveau d'une partie supérieure de cette chambre de dépôt 6, le dispositif 1 comporte des moyens d'injection 9 d'une puissance micro-ondes. Les moyens d'injection 9 sont disposés de telle sorte que les micro-ondes sont introduites dans le dispositif 1 de manière à passer au travers d'un guide d'ondes 10, puis à transiter par une fenêtre d'étanchéité aux micro-ondes 12, de préférence en quartz ou en alumine. Les micro-ondes sont ensuite orientées vers l'intérieur de la chambre de dépôt 6, de préférence, pour limiter le coût du dispositif, à une fréquence d'environ 2,45 GHz et à une puissance d'environ 500 W.

Le dispositif 1 comprend en outre des moyens d'injection 13,14 aptes à introduire à l'intérieur de la chambre de dépôt 6 un gaz contenant du carbone, ces moyens 13,14 étant notamment constitués d'un tuyau 14 d'acheminement du gaz et d'une vanne de fuite 13.

Le gaz contenant du carbone est préférablement choisi parmi les alcanes, les alcènes, les alcynes, ainsi que leurs mélanges. Plus particulièrement, on utilisera le méthane et l'acétylène.

Les moyens d'injections 13,14 du gaz sont destinés à opérer des injections à faible pression. Il est à noter que l'on entend par faible pression une pression sensiblement inférieure à environ $3.10^{-3}$ mbar, et de préférence égale à environ $8.10^{-4}$ mbar.

De plus, le dispositif 1 comprend des moyens 17,18 permettant de créer un champ magnétique à l'intérieur de la chambre de dépôt 6, ces moyens comportant un aimant permanent 17 situé sous la chambre de dépôt 6, ainsi qu'un carter d'aimant permanent 18.

Les moyens pour créer le champ magnétique comprennent également des bobines de champ magnétique 19,20,21, situées au-dessus de la chambre de dépôt 6, entourant le guide d'ondes 10.

Le dispositif 1 est aussi muni d'au moins une zone de résonance cyclotron électronique 16, cette dernière se situant à l'intérieur de la chambre de dépôt 6, en regard du substrat 8.

La zone de résonance cyclotron électronique 16 est une zone de champ magnétique telle que le module du champ magnétique vérifie la relation suivante :

$$w_{HF} = w_{CE} = (q_e . B_r)/m_e \quad \text{avec :}$$

- $w_{HF}$ : pulsation de l'onde haute fréquence injectée ;
- $W_{CE}$ : pulsation cyclotronique des électrons ;
- $q_e$ : charge de l'électron ;
- $B_r$ : champ de résonance ;
- $m_e$ : masse de l'électron.

A titre d'exemple, quel que soit le gaz utilisé, l'injection de la puissance micro-ondes a lieu à une fréquence de 2,45 GHz, pour une valeur du champ magnétique, correspondant à la résonance cyclotron électronique, de l'ordre de 875 Gauss.

De préférence, le champ magnétique appliqué dans la chambre de dépôt 6 est du type miroir magnétique fortement déséquilibré. Le champ magnétique est maximum dans la partie supérieure de la chambre de dépôt 6 au niveau de l'injection de la puissance micro-ondes. Ce même champ magnétique est ensuite minimum au niveau du centre de la chambre de dépôt 6, puis grandit à nouveau lorsque l'on s'approche du substrat 8.

Toujours à titre d'exemple, au niveau de l'injection micro-ondes, le champ magnétique a une valeur de 2700 Gauss, alors qu'au centre de la chambre de dépôt 6, la valeur de ce champ magnétique est d'environ 500 Gauss.

Il est à noter qu'en référence à la figure 1, des lignes équimodules de champ magnétique 44,45,46,47 sont représentées, les lignes équimodules 44,45 représentant la région de la chambre de dépôt 6 dans laquelle le champ magnétique a une valeur de 500 Gauss. Notons qu'au niveau de la zone à résonance cyclotron électronique 16, on dispose d'une valeur du champ magnétique d'environ 875 Gauss.

Le dispositif 1 comprend également un écran 22 délimitant une zone de dépôt 24, adjacente à au moins une partie du substrat 8 comprenant les deux éléments électriquement conducteurs 4. De préférence, la distance entre l'écran 22 et le substrat 8 est comprise entre environ 0,1 et 10 mm.

Préférentiellement, l'écran 22 est une plaque métallique positionnée sensiblement perpendiculairement aux lignes de champs 26 du champ magnétique appliqué.

Dans une configuration préférée, la plaque métallique 22 dispose d'une forme approximative de rectangle, mais peut bien entendu prendre toute autre forme, selon les besoins rencontrés.

Pareillement, le substrat 8 est également placé sensiblement perpendiculairement aux lignes de champ 26 du champ magnétique appliqué à l'intérieur de la chambre de dépôt 6.

Selon un mode de réalisation préféré de l'invention, le substrat 8 est chauffé au moyen d'un filament 40 et d'une connexion de chauffage 42. Ce chauffage permet notamment de fournir l'énergie d'activation nécessaire à la croissance du nanotube 2. La température du substrat 2 est alors comprise entre environ 500°C et environ 700°C.

Le dispositif 1 est apte à fonctionner de la manière suivante.

L'injection d'une puissance micro-ondes dans la chambre de dépôt 6, où règne une structure magnétique de type miroir magnétique à fort confinement magnétique, provoque la dissociation et/ou l'ionisation du gaz contenant du carbone, également injecté dans la chambre de dépôt 6, par l'intermédiaire des moyens d'injection du gaz 13,14.

A titre d'exemple, lors d'une injection de méthane, on assiste aux réactions chimiques suivantes :

$$e + CH_4 \rightarrow CH_3^+ + H° + e + e \; ;$$

$$e + CH_4 \rightarrow CH_3° + H° + e.$$

Toujours à titre d'exemple, si le gaz utilisé est l'acétylène, on assiste aux réactions chimiques suivantes :

$$e + C_2H_4 \rightarrow C_2H_3^+ + H° + e + e \; ;$$

$$e + C_2H_4 \rightarrow C_2H_3° + H° + e.$$

Dans chacun des cas, on obtient ainsi des radicaux libres non-condensables du type $CxHy°$. Ces radicaux réactifs sont les espèces que l'on désire faire pénétrer à l'intérieur de la zone de dépôt 24 du dispositif 1, afin d'aboutir à la formation de nanotubes de qualité. Par exemple, on pourra obtenir des nanotubes pleins ou des nanotubes à simple paroi.

Dans les espèces produites suite à l'ionisation et/ou la dissociation du gaz contenant du carbone, on compte notamment des électrons et des ions du type $C^+$, $C_2^+$, qui sont des espèces directement condensables, susceptibles de se déposer en tout lieu. De plus on peut également noter la présence d'ions non-condensables du type $CxHy^+$. Les éléments qui viennent d'être cités n'étant en aucun cas favorables à la croissance de nanotubes et/ou de nanofils tels que ceux que l'on désire obtenir entre les éléments électriquement conducteurs 4, le dispositif 1 a été conçu afin d'interdire à ces éléments l'accès à la zone de dépôt 24, dans laquelle se trouvent les éléments électriquement conducteurs 4 à raccorder.

Les espèces condensables ionisées ainsi que les espèces non-condensables ionisées citées ci-dessus sont magnétisées, et diffusent donc de haut en bas dans la chambre de dépôt 6, en direction du substrat 8, le long des lignes de champ 26 du champ magnétique appliqué. Notons, comme cela est représenté sur la figure 2, que les électrons s'enroulent autour des lignes de champ 26 suivant la force de Laplace, et diffusent le long de ces lignes 26.

Par conséquent, avec un tel agencement, les espèces ionisées produites, du type $C^+$, $C_2^+$, $CxHy^+$, se déposent indifféremment sur la plaque écran 22, ou sur une partie de la couche isolante 9 n'étant pas protégée par cette même plaque 22 (figure 2). L'effet combiné de leur localisation sur les lignes de champ 26 ainsi que le positionnement de la plaque écran 22 par rapport à la direction des lignes de champ 26, interdit à ces espèces ionisées l'accès à la zone de dépôt 24.

En revanche, les radicaux libres non-magnétisés du type $CxHy°$ circulent librement . à l'intérieur de la chambre de dépôt 6, sans être soumis à une direction de propagation imposée. Ainsi, lorsqu'ils arrivent à proximité de la plaque écran 22, l'absence de direction imposée leur permet de pénétrer à l'intérieur de la zone de dépôt 24, dans laquelle se trouve les éléments électriquement conducteurs 4.

De cette façon, dans la zone de dépôt 24 adjacente à une partie du substrat 8 comprenant les deux éléments électriquement conducteurs 4, ne sont présents que les radicaux libres non-condensables mentionnés ci-dessus. Cette caractéristique spécifique permet d'obtenir un nanotube 2 de très bonne qualité entre les éléments électriquement conducteurs 4, et non une pluralité de nanotubes agencés selon une configuration du type « toile d'araignée », qui pourrait être provoquée par la présence des espèces aptes à se déposer de façon non-sélective.

Notons que les dépôts de carbone non-sélectif engendrés par les espèces condensables du type $C^+$, $C_2^+$, aussi bien sur la plaque écran 22 que sur la partie du substrat 8 non protégée par cette même plaque 22, sont représentés par la référence 29 sur la figure 2.

En pénétrant dans cette zone de dépôt 24, les radicaux libres non-condensables se fixent tout d'abord sur l'un des deux éléments électriquement conducteurs 4 à raccorder, en établissant une liaison carbone-métal. Une fois la fixation réalisée, il se crée une déshydrogénation catalytique de ces composés du type CxHy°.

Les atomes de carbone en solution diffusent dans et/ou sur l'élément électriquement conducteur 4 pour précipiter et créer un nanotube de carbone 2, qui progresse ensuite en direction de l'autre élément électriquement conducteur 4, tout en restant en contact du substrat 8.

Il est précisé que la direction de croissance des nanotubes 2 peut être davantage maîtrisée en procédant à l'adjonction d'un gradient thermique, d'un champ magnétique ou d'un champ électrique, dans la zone de dépôt 24. De même, il est également possible de cumuler plusieurs des éléments précités.

Avec un tel dispositif 1, on peut obtenir des nanotubes de carbone 2 ou des nanofils d'un diamètre mesurant de 1 à 100 nanomètres, le contact de ces nanotubes 2 avec les éléments électriquement conducteurs 4 étant très satisfaisant, en raison notamment de la continuité existant entre l'extrémité de ces nanotubes 2, et des éléments électriquement conducteurs 4.

L'invention concerne également un procédé de fabrication d'au moins un nanotube 2 reliant deux éléments électriquement conducteurs 4, susceptible d'être mis en oeuvre par un dispositif 1 tel que celui qui vient d'être décrit. Comme évoqué précédemment, les éléments électriquement conducteurs 4 se situent sur un substrat 8. Le procédé selon l'invention met en oeuvre une puissance micro-ondes dans une chambre de dépôt 6, cette dernière étant également soumise à un champ magnétique. A l'intérieur de la chambre de dépôt 6, on dispose d'une zone de résonance cyclotron électronique 16, de sorte qu'une introduction à faible pression d'un gaz contenant du carbone à l'intérieur de cette chambre de dépôt 6 entraîne l'ionisation et/ou la dissociation de ce gaz dans la zone de résonance cyclotron électronique 16. Le procédé comprend en outre une opération d'écrantage des différentes espèces produites dans la zone de résonance cyclotron électronique 16. Lors de cette opération d'écrantage, uniquement les radicaux libres non-condensables du type CxHy° sont autorisés à pénétrer dans une zone de dépôt 24, adjacente à au moins une partie du substrat 8 comprenant les éléments électriquement conducteurs 4, pour réaliser le nanotube 2.

Bien entendu, diverses modifications peuvent être apportées par l'homme du métier au procédé et au dispositif qui viennent d'être décrits, uniquement à titre d'exemples non limitatifs.

## Revendications

1. Procédé de fabrication d'au moins un nanotube (2) entre deux éléments électriquement conducteurs (4) situés sur un substrat (8), ledit procédé mettant en oeuvre, dans une chambre de dépôt (6), une puissance micro-ondes, un champ magnétique, ainsi qu'au moins une zone de résonance cyclotron électronique (16) favorisant l'ionisation et/ou la dissociation d'un gaz contenant du carbone injecté dans la chambre de dépôt (6),
l'injection du gaz contenant du carbone étant réalisée à faible pression à l'intérieur de la chambre de dépôt (6), entraînant l'ionisation et/ou la dissociation de ce gaz dans chaque zone de résonance cyclotron électronique (16), les ions et les électrons produits étant localisés sur les lignes de champ (26) du champ magnétique mis en oeuvre dans la chambre de dépôt (6),
**caractérisé en ce que** le procédé comprend en outre une opération d'écrantage des différentes espèces produites dans chaque zone de résonance cyclotron électronique (16), afin d'autoriser exclusivement aux radicaux libres non-condensables produits du type CxHy°, l'accès à une zone de dépôt (24) adjacente à au moins une partie du substrat (8) comprenant les deux éléments électriquement conducteurs (4), pour réaliser ledit nanotube (2).

2. Procédé selon la revendication 1 **caractérisé en ce que** l'opération d'écrantage est réalisée en interposant une plaque métallique (22) entre la zone de résonance cyclotron électronique (16) et les éléments électriquement conducteurs (4), ladite plaque métallique (22) étant sensiblement perpendiculaire aux lignes de champ (26) du champ magnétique appliqué dans la chambre de dépôt (6), de sorte que les ions et les électrons produits ne pénètrent pas dans la zone de dépôt (24).

3. Procédé selon la revendication 1 ou la revendication 2, **caractérisé en ce qu'**une direction de croissance de chaque nanotube est favorisée par l'application, dans ladite zone de dépôt (24), d'au moins l'un des éléments pris parmi le groupe constitué d'un gradient thermique, d'un champ magnétique ou d'un champ électrique.

4. Procédé selon l'une quelconque des revendications précédentes, **caractérisé en ce qu'**il comprend les étapes suivantes :

- chauffage du substrat (8),
- mise en oeuvre de la puissance micro-ondes à l'intérieur de la chambre de dépôt (6),
- injection du gaz contenant du carbone,
- application du champ magnétique à l'intérieur de la chambre de dépôt (6), de façon à créer des lignes de champ (26) sensiblement perpendiculaires audit substrat (8) et entraîner l'ionisation et/ou la dissociation du gaz dans chaque zone de résonance cyclotron électronique (16), de sorte que les ions et les électrons produits soient localisés sur les lignes de champ (26) dudit champ magnétique,
- écrantage des espèces produites afin d'autoriser exclusivement aux radicaux libres non-condensables du type CxHy° l'accès à ladite zone de dépôt (24).

5. Procédé selon la revendication 4, **caractérisé en ce que** l'opération de chauffage du substrat (8) se réalise à une température comprise entre environ 500°C et environ 700°C.

6. Procédé selon l'une quelconque des revendications précédentes, **caractérisé en ce que** la fréquence de la puissance micro-ondes mise en oeuvre dans la chambre de dépôt (6) est d'environ 2,45 GHz.

7. Procédé selon l'une quelconque des revendications précédentes, **caractérisé en ce que** le gaz contenant du carbone est choisi parmi les alcanes, les alcènes, les alcynes, ainsi que leurs mélanges.

8. Procédé selon l'une quelconque des revendications précédentes, **caractérisé en ce que** la faible pression d'injection du gaz contenant du carbone est inférieure à environ $3.10^{-3}$ mbar.

9. Procédé selon l'une quelconque des revendications précédentes, **caractérisé en ce que** le champ magnétique appliqué dans la chambre de dépôt (6) est du type miroir magnétique fortement déséquilibré, le champ magnétique étant maximum à l'injection de la puissance micro-ondes, minimum au centre de la chambre de dépôt (6) et grandissant à nouveau en approchant du substrat (8).

10. Procédé selon l'une quelconque des revendications précédentes, **caractérisé en ce que** les éléments électriquement conducteurs (4) comprennent au moins une zone contenant au moins un élément choisi parmi le fer, le nickel, le cobalt ou tout autre métal ou alliage ayant des propriétés catalytiques de fixation et de déshydrogénation des radicaux libres non-condensables du type CxHy°.

11. Dispositif (1) pour réaliser au moins un nanotube (2) entre deux éléments électriquement conducteurs (4) se situant sur un substrat (8), ledit dispositif (1) comprenant :

- une chambre de dépôt (6),
- des moyens d'injection (9) d'une puissance micro-ondes à l'intérieur de la chambre de dépôt (6),
- des moyens (17,18,19,20,21) permettant de créer un champ magnétique à l'intérieur de la chambre de dépôt (6),
- au moins une zone de résonance cyclotron électronique (16) à l'intérieur de la chambre de dépôt (6),
- des moyens d'injection (13,14) aptes à introduire à faible pression un gaz contenant du carbone, à l'intérieur de la chambre de dépôt (6),

**caractérisé en ce que** le dispositif (1) comprend de plus :

- un écran (22) délimitant une zone de dépôt (24) adjacente à au moins une partie du substrat (8) comprenant les deux éléments électriquement conducteurs (4) et uniquement accessible aux radicaux libres non-condensables du type CxHy°.

12. Dispositif (1) selon la revendication 11, **caractérisé en ce que** l'écran (22) a une forme approximative de rectangle.

13. Dispositif (1) selon la revendication 11 ou la revendication 12, **caractérisé en ce que** l'écran (22) est une plaque métallique positionnée sensiblement perpendiculairement aux lignes de champ (26) du champ magnétique, sur lesquelles sont localisées les ions et les électrons produits dans la zone de résonance cyclotron électronique (16).

**14.** Dispositif (1) selon l'une quelconque des revendications 11 à 13, **caractérisé en ce que** le substrat (8) est sensiblement perpendiculairement aux lignes de champ (26) du champ magnétique appliqué à l'intérieur de la chambre de dépôt (6).

**Claims**

**1.** Process for making at least one nanotube (2) between two electrically conducting elements (4) located on a substrate (8), the said process using, inside a deposition chamber (6), a microwave power, a magnetic field, and at least one electronic cyclotron resonance zone (16) facilitating ionization and / or dissociation of a gas containing carbon injected into the deposition chamber (6),
the gas containing carbon being injected at low pressure inside the deposition chamber (6), causing ionization and / or dissociation of this gas in each electronic cyclotron resonance zone (16), the ions and electrons produced being located along the field lines (26) of the magnetic field set up in the deposition chamber (6),
**characterized in that** the process also comprises a screening operation of the various species produced in each electronic cyclotron resonance zone (16) to enable exclusive access of $CxHy°$ type non condensable free radicals produced to access a deposition zone (24) adjacent to at least one part of the substrate (8) comprising the said two electrically conducting elements (4) to make the said nanotube (2).

**2.** Process according to claim 1, **characterized in that** the screening operation is made by inserting a metallic plate (22) between the electronic cyclotron resonance zone (16) and the electrically conducting elements (4), the said metallic plate (22) being approximately perpendicular to the field lines (26) of the magnetic field applied in the deposition chamber (6), such that the ions and electrons produced do not penetrate into the deposition zone (24).

**3.** Process according to claim 1 or claim 2, **characterized in that** a direction of growth of each nanotube is made preferential by the application of at least one of the elements from the group composed of a temperature gradient, a magnetic field and an electric field, in the said deposition zone (24).

**4.** Process according to any one of the previous claims, **characterized in that** it comprises the following steps:

- heat the substrate (8),
- apply the microwave power inside the deposition chamber (6),
- inject the gas containing carbon,
- apply the magnetic field inside the deposition chamber (6), so as to create field lines (26) approximately perpendicular to the said substrate (8) and cause ionization and / or dissociation of the gas in each electronic cyclotron resonance zone (16), such that the ions and the electrons produced are located on the field lines (26) of the magnetic field,
- screen the species produced to enable exclusively $CxHy°$ type non-condensable free radicals to access the deposition zone (24).

**5.** Process according to claim 4, **characterized in that** the heating operation of the substrate (8) takes place at a temperature of between about 500°C and about 700°C.

**6.** Process according to any one of the previous claims, **characterized in that** the frequency of the microwave power used in the deposition chamber (6) is about 2.45 GHz.

**7.** Process according to any one of the previous claims, **characterized in that** the gas containing carbon is chosen among alkanes, alkenes, alkynes and mixes of these gasses.

**8.** Process according to any one of the previous claims, **characterized in that** the low injection pressure of the gas containing carbon is less than about $3 \times 10^{-3}$ mbars.

**9.** Process according to any one of the previous claims, **characterized in that** the magnetic field applied in the deposition chamber (6) is of the highly unbalanced magnetic mirror type, the magnetic field being maximum at the injection of the microwave power, minimum at the center of the deposition chamber (6), and increasing again when approaching the substrate (8).

**10.** Process according to any one of the previous claims, **characterized in that** the electrically conducting elements (4) comprise at least one zone containing at least one element chosen from among iron, nickel, cobalt or any other metal or alloy with catalytic fixation and dehydrogenation properties of CxHy° type non condensable free radicals.

11. Device (1) for making at least one nanotube (2) between two electrically conducting elements (4) located on a substrate (8), the said device (1) comprising:

- a deposition chamber (6),
- means (9) for injecting microwave power inside the deposition chamber (6),
- means (17, 18, 19, 20, 21) for creating a magnetic field inside the deposition chamber (6),
- at least one electronic cyclotron resonance zone (16) inside the deposition chamber (6),
- injection means (13, 14) for introducing a gas containing carbon at low pressure inside the deposition chamber (6),

**characterized in that** the device (1) also comprises:

- a screen (22) delimiting a deposition zone (24) adjacent to at least part of the substrate (8) comprising the two electrically conducting elements (4) and accessible only to CxHy° type non-condensable free radicals.

12. Device (1) according to claim 11, **characterized in that** the shape of the screen (22) is approximately rectangular.

13. Device (1) according to claim 11 or claim 12, **characterized in that** the screen (22) is a metallic plate positioned approximately perpendicular to field lines (26) of the magnetic field, on which the ions and electrons produced in the electronic cyclotron resonance zone (16) are located.

14. Device (1) according to any one of claims 11 to 13, **characterized in that** the substrate (8) is approximately perpendicular to the field lines (26) of the magnetic field applied inside the deposition chamber (6).

## Patentansprüche

1. Verfahren zur Herstellung mindestens einer Nanoröhre (2) zwischen zwei elektrisch leitenden Elementen (4), die sich auf einem Substrat (8) befinden, wobei das Verfahren in einer Abscheidekammer (6) eine Mikrowellenleistung, ein Magnetfeld, sowie mindestens eine Elektron-Zyklotron-Resonanzzone (16) zur Anwendung bringt, um die Ionisierung und/oder die Dissoziierung eines Kohlenstoff enthaltenden Gases zu begünstigen, das in die Abscheidekammer (6) eingebracht wird, wobei das Einbringen des Kohlenstoff enthaltenden Gases in das Innere der Abscheidekammer (6) bei geringem Druck erfolgt, was die Ionisierung und/oder die Dissoziierung dieses Gases in jeder Elektron-Zyklafiran-Resonanzzone nach sich zieht, wobei die erzeugten Ionen und Elektronen sich auf den Feldlinien (26) des in der Abscheidekammer (6) realisierten Magnetfeldes befinden, **dadurch gekennzeichnet, dass** das Verfahren weiter eine Operation zur Abschirmung der in jeder Elektron-Zyklotron-Resonanzzone erzeugten unterschiedlichen Sorten umfasst, so dass ausschließlich den erzeugten nicht-kondensierbaren freien Radikalen vom Typ CxHy° der Zugang zu einer Abscheidezone (24) gestattet wird, die zumindest einem Teil des Substrates (8) benachbart ist, das die zwei elektrisch leitende Elemente (4) aufweist, um die Nanoröhre (2) zu realisieren.

2. Verfahren nach Anspruch 1, **dadurch gekennzeichnet, dass** die Abschirmungsoperation realisiert wird, indem man eine Metallplatte (22) zwischen der Elektron-Zyklotron-Resonanzzone (16) und den elektrisch leitenden Elementen (4) anordnet, wobei die Metallplatte (22) im Wesentlichen senkrecht zu den Feldlinien (26) des in der Abscheidekammer (6) eingesetzten Magnetfeldes ist, so dass die erzeugten Ionen und Elektronen nicht in die Abscheidezone (24) eindringen.

3. Verfahren nach Anspruch 1 oder Anspruch 2, **dadurch gekennzeichnet, dass** eine Wachstumsrichtung einer jeden Nanoröhre dadurch begünstigt wird, dass in der Abscheidezone (24) mindestens eines der Elemente zur Anwendung kommt, die aus der Gruppe gewählt sind, welche aus einem Wärmegradienten, einem Magnetfeld oder einem elektrischen Feld besteht.

4. Verfahren nach einem der vorhergehenden Ansprüche, **dadurch gekennzeichnet, dass** es die folgenden Schritte umfasst:

Erwärmen des Substrates (8),

Einsetzen der Mikrowellenleistung im Inneren der Abscheidekammer (6),

Einbringen des Kohlenstoff enthaltenden Gases,

Aufbringen des Magnetfeldes im Inneren der Abscheidekammer (6), um Feldlinien (26) zu erzeugen, die im Wesentlichen senkrecht zum Substrat (8) sind, und um die Ionisierung und/oder die Dissoziierung des Gases in jeder Elektron-Zyklotron-Resonanzzone (16) anzutreiben, so dass die erzeugten Ionen und Elektronen sich auf den Feldlinien (26) des Magnetfeldes befinden,

Abschirmung von erzeugten Sorten, um ausschließlich nicht-kondensierbaren freien Radikalen vom CxHy°-Typ den Zugang zur Abscheidezone (24) zu gestatten.

5. Verfahren nach Anspruch 4, **dadurch gekennzeichnet, dass** die Operation des Erwärmen des Substrates (8) bei einer Temperatur zwischen ca. 500 °C und ca. 700 °C erfolgt.

6. Verfahren nach einem der vorhergehenden Ansprüche, **dadurch gekennzeichnet, dass** die Frequenz der Mikrowellenleistung, die in der Abscheidekammer (6) zur Anwendung kommt, ungefähr 2,45 GHz beträgt

7. Verfahren nach einem der vorhergehenden Ansprüche, **dadurch gekennzeichnet, dass** das Kohlenstoff enthaltende Gas aus Alkanen, Alkenen, Alkinen, sowie Gemischen aus diesen gewählt wird.

8. Verfahren nach einem der vorhergehenden Ansprüche, **dadurch gekennzeichnet, dass** der geringe Einbringungsdruck des Kohlenstoff enthaltenden Gases unterhalb ca. $3 \times 10^{-3}$ mbar liegt.

9. Verfahren nach einem der vorhergehenden Ansprüche, **dadurch gekennzeichnet, dass** das Magnetfeld, das in der Abscheidekammer (6) zur Anwendung kommt, vom Typ eines stark unsymmetrischen magnetischen Spiegels ist, wobei das Magnetfeld an der Einbringung der Mikroweilenleistung maximal ist, in der Mitte der Abscheidekammer (6) minimal ist, und bei Annäherung an das Substrat (8) erneut zunimmt.

10. Verfahren nach einem der vorhergehenden Ansprüche, **dadurch gekennzeichnet, dass** die elektrisch leitenden Elemente (4) mindestens eine Zone aufweisen, die mindestens ein Element enthält, das aus Eisen, Nickel, Kobalt oder jeglichem anderen Metall oder Legierung gewählt ist, das/die katalytische Eigenschaften zur Bildung oder Dehydrierung nicht-kondensierbarer freier Radikale vom Typ CxHy° hat.

11. Vorrichtung (1), um mindestens eine Nanoröhre (2) zwischen zwei elektrisch leitenden Elementen (4) zu realisieren, die sich auf einem Substrat (8) befinden, wobei die Vorrichtung (1) aufweist:

eine Abscheidekammer (6),

Einrichtungen zum Einbringen (9) einer Mikroweilenleistung ins Innere der Abscheidekammer (6),

Einrichtungen (17, 18, 19, 20, 21), die ermöglichen, ein Magnetfeld im Inneren der Abscheidekammer (6) zu erzeugen,

mindestens eine Elektron-Zyklotron-Resonanzzone (16) im Inneren der Abscheidekammer (6),

Einbringungseinrichtungen (13, 14), die geeignet sind, ein Kohlenstoff enthaltendes Gas mit geringem Druck ins Innere der Abscheidekammer (6) einzubringen,

**dadurch gekennzeichnet, dass** die Vorrichtung (1) weiter aufweist:

eine Abschirmung (22), die eine Abscheidezone (24) benachbart zu mindestens einem Teil des Substrates (8) begrenzt, das die zwei elektrisch leitenden Elemente (4) enthält, und die ausschließlich für nicht-kondensierbare freie Radikale vom Typ CxHy° zugänglich ist.

12. Vorrichtung (1) nach Anspruch 11, **dadurch gekennzeichnet, dass** die Abschirmung (22) näherungsweise die Form eines Rechtecks hat.

13. Vorrichtung (1) nach Anspruch 11 oder Anspruch 12, **dadurch gekennzeichnet, dass** die Abschirmung (22) eine Metallplatte ist, die im Wesentlichen senkrecht zu den Feldlinien (26) des Magnetfeldes ist, auf denen die Ionen und die Elektronen lokalisiert sind, welche in der Elektron-Zyklotron-Resonanzzone (16) erzeugt werden.

14. Vorrichtung (1) nach einem der Ansprüche 11 bis 13, **dadurch gekennzeichnet, dass** das Substrat (8) im Wesentlichen senkrecht zu den Feldlinien (26) des im Inneren der Abscheidekammer (6) angelegten Magnetfeldes ist.

FIG. 1

**FIG. 2**

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0234669 A

**Littérature non-brevet citée dans la description**

- **C. BOWER et al.** *Applied Physics Letters,* 2000, vol. 77, 830
- **Y.C. CHOI et al.** *Journal of Applied Physics,* 2000, vol. 88, 4898
- **H. POSTMA et al.** *Advanced Material,* 2000, 1299
- **H.T. SOH et al.** *Applied Physics Letters,* 1999, vol. 75 (5), 627
- **Y.Y. WEI ; G. ERES.** *Applied Physics Letters,* 2000, vol. 76 (25), 3759